(19) Europäisches Patentamt
European Patent Office
Office européen des brevets

(11) EP 0 504 569 B1

(12) EUROPÄISCHE PATENTSCHRIFT

(45) Veröffentlichungstag und Bekanntmachung des Hinweises auf die Patenterteilung:
**10.09.1997 Patentblatt 1997/37**

(51) Int Cl.6: **C08G 59/68**, G03F 7/029

(21) Anmeldenummer: **92101885.9**

(22) Anmeldetag: **05.02.1992**

# (54) Verfahren zur Beschichtung oder Verklebung von elektronischen Bauelementen und Baugruppen

Method of coating or sealing of electronic components or component groups

Procédé pour le revêtement ou le scellement

(84) Benannte Vertragsstaaten:
**BE CH DE FR GB IT LI NL**

(30) Priorität: **18.02.1991 DE 4104958**

(43) Veröffentlichungstag der Anmeldung:
**23.09.1992 Patentblatt 1992/39**

(73) Patentinhaber: **SIEMENS AKTIENGESELLSCHAFT**
**80333 München (DE)**

(72) Erfinder:
- **Schön, Lothar, Dipl.-Ing. (FH)**
  **W-8524 Neunkirchen (DE)**
- **Stapp, Bernhard, Dr.**
  **W-8501 Kalchreuth (DE)**
- **Bayer, Heiner, Dr.**
  **W-8037 Olching (DE)**
- **Markert, Helmut, Dr.**
  **W-8500 Nürnberg 40 (DE)**
- **Muhrer, Volker, Dipl.-Ing. (FH)**
  **W-8510 Fürth (DE)**

(56) Entgegenhaltungen:
**GB-A- 2 014 144**

- **DATABASE WPIL Week 0487, Derwent Publications Ltd., London, GB; AN 87-026302**
- **DATABASE WPIL Week 0182, Derwent Publications Ltd., London, GB; AN 82-00504E**
- **Patent Abstracts of Japan, Vol. 7, No. 118 (C-167) & JP-A-58037003**

EP 0 504 569 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die Erfindung betrifft ein Verfahren zur Beschichtung oder Verklebung von elektronischen Bauelementen und Baugruppen mit lagerstabilen Reaktionsharzmischungen.

Als Reaktionsharze zur Beschichtung, d.h. Lackierung, Abdeckung oder Umhüllung, bzw. zur Verklebung elektronischer Bauelemente und Baugruppen dienen vielfach Epoxidharze, die - im Verlauf einer Polyadditionsreaktion - mit Carbonsäureanhydriden, Aminen oder Mercaptanen thermisch gehärtet werden ("Advances in Polymer Science", Vol. 80 (1986), Seiten 173 bis 202). Bekannt sind ferner thermisch härtbare Epoxidharzmischungen, bei denen der Härtungsreaktion eine Polymerisation der Epoxidharze zugrundeliegt. Die Polymerisation kann dabei durch tertiäre Amine oder Lewissäuren (C.A. May, Y. Tanaka "Epoxy Resins", Marcel Dekker Inc., New York 1973, Seiten 283 bis 296) oder durch Oniumsalze bewirkt werden. So ist es aus der US-PS 4 216 288 bekannt, ein aromatisches Oniumsalz als Initiator zu verwenden, wobei zusätzlich reduzierende Agenzien vorhanden sein können. Aus der JP-OS 56-152833 sind thermisch härtbare Epoxidharzzusammensetzungen bekannt (siehe: "Chemical Abstracts", Vol. 96 (1982), No. 182205h), die Sulfoniumsalze und - als beschleunigendes Agens - Thiophenol enthalten. Beschrieben sind ferner lagerstabile, thermisch härtbare Mischungen, die Benzylthiolaniumsalze aufweisen (JP-OS 58-037003 bzw. "Chemical Abstracts", Vol. 99 (1983), No. 141034v).

Nachteilig bei der thermischen Härtung von Epoxidharzen ist häufig die Viskositätserniedrigung der Harze in der Aufwärmphase zur Härtung. Dies führt beispielsweise bei Lackierungen zu ungleichmäßigen Schichtstärken und sogenannten Lacknasen und bei der lokalen Abdeckung ungehäuster, gebondeter IC's auf Leiterplatten und Hybridschaltungen mittels eines Reaktionsharztropfens zu einem unerwünschten Zerfließen der Tropfenkontur. Thermische Härtungsprozesse sind darüber hinaus für automatisierte Bandabläufe nur bedingt geeignet, da die Härtung zeit- und platzintensiv ist.

Neben der thermisch aktivierten Härtung von Epoxidharzen sind auch Härtungsreaktionen bekannt, die - in Gegenwart von Photoinitiatoren - durch UV-Strahlung ausgelöst werden; wirksame Photoinitiatoren sind dabei Triarylsulfoniumsalze (siehe beispielsweise: US-PS 4 058 401, 4 138 255 und 4 173 476). Ein wesentliches Merkmal der UV-initiierten Härtung besteht darin, daß die Härtungsreaktion nur in den lichtzugänglichen Bereichen erfolgt. Es ist zwar bekannt, daß die mit Triarylsulfoniumsalzen initiierten Reaktionen auch nach Beendigung der UV-Bestrahlung weiterlaufen (siehe: N.S. Allen "Developments in Polymer Photochemistry - 2", Applied Science Publishers Ltd., London 1981, Seiten 13 und 14), dies erfolgt aber nur in den Bereichen, wo der Photoinitiator durch UV-Strahlung fragmentiert wurde. Eine thermische Härtung kann mit Triarylsulfoniumsalzen aber nicht initiiert werden (siehe: "Farbe + Lack", 93. Jahrg. (1987), Seiten 803 bis 807). Deshalb können UV-härtbare Epoxidharzmischungen auf dem Gebiet der Elektronik nur begrenzt Anwendung finden, da beim Beschichten (Lackieren, Abdecken, Umhüllen) und Verkleben von elektronischen Bauelementen und Baugruppen häufig lichtabgeschattete Bereiche vorliegen.

Diese Problematik zeigt sich beispielsweise bei der Lackierung von Leiterplattenflachbaugruppen. Dabei werden die Lacke - zum Schutz der Schaltung vor aggressiven Umgebungseinflüssen - meistens durch Tauchen auf die Flachbaugruppen aufgebracht. Ein UV-härtbarer Lack, der aus technischen und wirtschaftlichen Gründen von Vorteil wäre, kann hierbei nicht eingesetzt werden, da der Lack beim Tauchen auch in Bereiche, beispielsweise Spalte zwischen Leiterplatte und Bauelementen, eindringt, wo er von der UV-Strahlung nicht erfaßt wird und deshalb auch nicht gehärtet werden kann.

Die Verwendung UV-härtbarer Epoxidharze ist auch dann nicht möglich, wenn das UV-Licht durch Zusatzstoffe, wie Füllstoffe, Pigmente, Farbstoffe und Photoinitiatoren, oder sonstige Harzkomponenten in den oberen Schichten so stark absorbiert oder gestreut wird, daß in den tieferen Schichten keine ausreichende UV-Intensität mehr vorhanden ist. Dies ist beispielsweise bei der lokalen Abdeckung ungehäuster IC's auf Hybridschaltungen mittels eines Reaktionsharztropfens der Fall. Ein derartiges Reaktionsharz muß aus technischen Gründen mit mineralischen Füllstoffen hochgefüllt und außerdem mit Ruß oder einem Farbstoff versetzt sein. Dadurch wird aber ein Eindringen der UV-Strahlung in tiefere Bereiche verhindert.

Aufgabe der Erfindung ist es, ein Verfahren zur Beschichtung oder Verklebung von elektronischen Bauelementen und Baugruppen mit lagerstabilen Reaktionsharzmischungen anzugeben, das es ermöglicht, daß die Reaktionsharzmischungen sowohl an lichtzugänglichen als auch an lichtabgeschatteten Stellen gehärtet werden können.

Dies wird erfindungsgemäß dadurch erreicht, daß Reaktionsharzmischungen verwendet werden, die

- ein kationisch härtbares, lösungsmittelfreies Epoxidharz,
- ein Triarylsulfoniumsalz mit Hexafluorophosphat, Hexafluoroarsenat oder Hexafluoroantimonat als Anion, mit einem Massengehalt von 0,01 bis 5 % (bezogen auf Epoxidharz), und
- ein Benzylthiolaniumsalz mit Hexafluorophosphat, Hexafluoroarsenat oder Hexafluoroantimonat als Anion, mit einem Massengehalt von 0,01 bis 5 % (bezogen auf Epoxidharz), sowie
- gegebenenfalls übliche Zusatzstoffe enthalten,

und daß die Reaktionsharzmischungen durch UV-Bestrahlung und thermisch gehärtet werden.

Es hat sich nämlich überraschenderweise gezeigt, daß Triarylsulfoniumsalze und Benzylthiolaniumsalze in kationisch härtbaren Epoxidharzmischungen gleichzeitig vorhanden sein können und daß dabei dennoch eine so hohe Lagerstabilität erreicht wird, daß die Mischungen als Einkomponentensysteme auch noch nach mehreren Monaten verarbeitet werden können. In technischer Hinsicht ist ferner von Vorteil, daß einerseits die Mischungen eine hohe UV-Reaktivität aufweisen und andererseits bei mäßigen Temperaturen eine thermische Härtung erfolgen kann. Mit dem erfindungsgemäßen Verfahren ist es deshalb möglich, eine Beschichtung bzw. Verklebung von elektronischen Bauelementen und Baugruppen durchzuführen, auch wenn lichtabgeschattete Bereiche vorhanden sind, wie dies unterhalb von Bauelementen und in tieferen Schichten der Fall ist.

Beim erfindungsgemäßen Verfahren ist ferner von Vorteil, daß lösungsmittelfreie Reaktionsharzmischungen eingesetzt werden. Bei der Herstellung von Schutzbeschichtungen auf Leiterplattenflachbaugruppen werden bislang nämlich lösungsmittelhaltige Lacksysteme eingesetzt, bei denen die Filmbildung durch physikalische Trocknung erfolgt, d. h. durch Verdunsten oder Verdampfen der Lösungsmittel. Die Verwendung von organischen Lösungsmitteln zur Verdünnung der Bindemittel bis auf eine verarbeitbare Viskosität ist aber aus verschiedenen Gründen nachteilig. Der niedere Flammpunkt der Lösungsmittel und die damit verbundene Explosions- und Brandgefahr erfordert einerseits kostenintensive Schutz- und Überwachungsmaßnahmen bei der Lackherstellung und -verarbeitung. Zum Schutz der Umwelt ist es andererseits erforderlich, die Abluft von Heißluftöfen unter hohem Kostenaufwand von den organischen Lösungsmitteln zu reinigen. Bei der Tauchlackierung ist ferner zu berücksichtigen, daß das aus dem Tauchbecken verdunstende Lösungsmittel ständig ersetzt werden muß, um bei der Verarbeitung eine gleichbleibende Lackviskosität sicherzustellen. Diese Probleme werden beim erfindungsgemäßen Verfahren durch die Verwendung eines lösungsmittelfreien und dennoch niederviskosen Systems vermieden. Deshalb kann beispielsweise bei der Lackierung von Flachbaugruppen der Lack die Bauelemente unterfluten, d.h. auch in die engen Spalte zwischen Bauelement und Leiterplatte eindringen.

Beim erfindungsgemäßen Verfahren werden die Reaktionsharzmischungen, wie bereits ausgeführt, sowohl durch UV-Bestrahlung als auch thermisch gehärtet. Die thermische Härtung erfolgt dabei vorteilhaft bei Temperaturen von 80 bis 200°C; vorzugsweise wird bei Temperaturen von 80 bis 150°C gehärtet.

Als Epoxidharz finden beim erfindungsgemäßen Verfahren vorzugsweise Glycidylether auf der Basis von Bisphenol A, Bisphenol F oder Novolaken Verwendung; geeignet sind beispielsweise aber auch Glycidylether von Glycerin und Pentaerythrit. Ferner werden lineare aliphatische Epoxidharze, wie epoxidiertes Polybutadien und epoxidiertes Sojabohnenöl, und cycloaliphatische Epoxidharze, beispielsweise 3,4-Epoxycyclohexylmethyl-3',4'-epoxycyclohexancarboxylat, bevorzugt. Letztere zeichnen sich insbesondere durch eine hohe Reaktivität sowie eine niedrige Viskosität aus. Ferner können auch Mischungen kationisch härtbarer Epoxidharze eingesetzt werden.

Zur Erhöhung der Härtungsgeschwindigkeit und zur Verbesserung der mechanischen Formstoffeigenschaften können den Epoxidharzmischungen vorteilhaft hydroxylgruppenhaltige organische Verbindungen zugesetzt werden, d.h. Hydroxyl- bzw. Polyhydroxylverbindungen, sowie deren Vinylether. Als hydroxylgruppenhaltige Verbindungen dienen vorzugsweise Polyoxyalkylenpolyole, Polyalkylenpolyole und cycloaliphatische Hydroxylverbindungen. Neben Vinylethern der genannten Art können auch andere vinylgruppenhaltige Verbindungen zum Einsatz gelangen.

Als Photoinitiatoren zur UV-Härtung der lichtzugänglichen Bereiche dienen vorzugsweise Triarylsulfoniumsalze folgender Struktur:

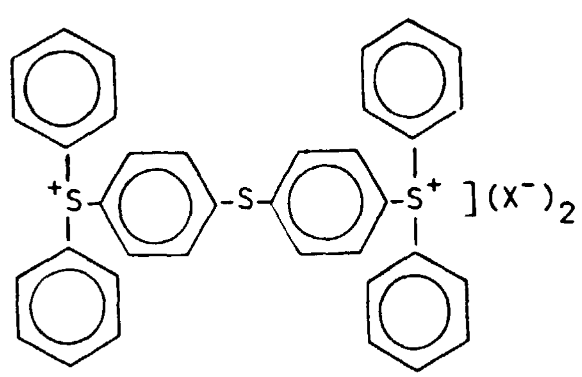

oder

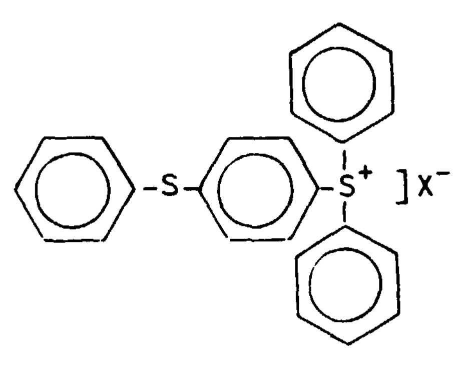

mit $X^- = PF_6^-$, $AsF_6^-$ oder $SbF_6^-$.

Beispielhaft seien dafür 4-Diphenylsulfoniodiphenylsulfid-hexafluoroantimonat und Bis[4-(diphenylsulfonio)phenyl]sulfid-bis-hexafluoroantimonat genannt. Die Triarylsulfoniumsalze finden in einer Konzentration von 0,01 bis 5 % Verwendung, bezogen auf Epoxidharz; vorzugsweise beträgt der Gehalt an Triarylsulfoniumsalz 0,05 bis 3 %.

Die Härtung der Reaktionsharzmischungen in Bereichen, die dem UV-Licht nicht zugänglich sind, beispielsweise unter Bauelementen oder in tieferen Schichten UV-lichtabsorbierender oder -streuender Epoxidharzformulierungen, wird durch ein thermisch aktivierbares Benzylthiolaniumsalz bewirkt. Dafür dienen vorzugsweise Benzylthiolaniumsalze folgender Struktur:

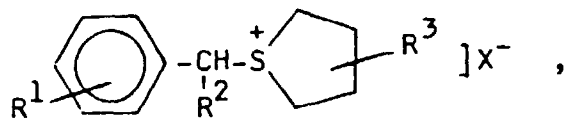

wobei folgendes gilt:

- $R^1$ = Wasserstoff, Alkyl, Aryl, Alkoxy, Thioether, Halogen, CN oder $NO_2$;
- $R^2$ = Wasserstoff, Alkyl oder Aryl;
- $R^3$ = Wasserstoff, Alkyl oder Aryl oder der Thiolanring ist Bestandteil eines aromatischen Systems;
- $X^-$ = $PF_6^-$, $AsF_6^-$ oder $SbF_6^-$.

Bevorzugt werden dabei unsubstituierte Benzylthiolaniumsalze eingesetzt, insbesondere wird Benzylthiolaniumhexafluoroantimonat verwendet. Die Benzylthiolaniumsalze finden in einer Konzentration von 0,01 bis 5 % Verwendung, bevorzugt in einer Konzentration von 0,05 bis 3 %, jeweils bezogen auf Epoxidharz.

Um die Lagerstabilität noch weiter zu erhöhen, können den Reaktionsharzmischungen vorteilhaft stabilisierende Komponenten zugesetzt werden. Als Stabilisatoren haben sich dabei tertiäre Amine, die in einer Konzentration von 0,001 bis 1 %, vorzugsweise 0,001 bis 0,05 %, jeweils bezogen auf Epoxidharz, eingesetzt werden, als vorteilhaft erwiesen. Als derartige tertiäre Amine werden Ethanolamine, wie Diisopropylaminoethanol und Triethanolamin, bevorzugt. Vorteilhaft können für den genannten Zweck aber auch (Meth)acrylate, in einer Konzentration von 1 bis 30 %, bezogen auf Epoxidharz, eingesetzt werden. Bevorzugt werden dabei Methacrylate, wie Polypropylenglykolmonomethacrylat. Verbindungen der genannten Art zeigen, bei den angegebenen Konzentrationen, eine hervorragende stabilisierende Wirkung, ohne jedoch die Reaktivität der Initiatoren wesentlich zu beeinflussen.

Als Zusatzstoffe können den Reaktionsharzmischungen nach der Erfindung mineralische oder organische Füllstoffe sowie weitere bekannte Zusätze und Additive, wie Thixotropiermittel, Entgasungshilfsmittel, Benetzungsmittel, Haftvermittler, Farbstoffe und Pigmente, zugegeben werden. Durch die Zusatzstoffe können die Eigenschaften der ungehärteten Mischungen bzw. die Formstoffeigenschaften verändert werden.

Das erfindungsgemäße Verfahren eignet sich zur Beschichtung und Verklebung von elektronischen Bauelementen und Baugruppen insbesondere dann, wenn hierbei - konstruktiv bedingt - lichtabgeschattete Bereiche auftreten und/oder die Eindringtiefe von UV-Strahlung in das Harz zu gering für eine vollständige Aushärtung ist. Bevorzugte Anwendungsgebiete sind die flächige Beschichtung von Baugruppen der Elektronik (mit lichtabgeschatteten Bereichen), insbesondere die Lackierung von Leiterplattenflachbaugruppen, sowie die lokale Abdeckung von mikroelektronischen Bauelementen, insbesondere ungehäusten, gebondeten IC's, wobei im letztgenannten Fall Farbstoff oder Pigment enthaltende Reaktionsharzmischungen mit einem hohen Anteil an mineralischen Füllstoffen zum Einsatz gelangen.

Die Härtung der lichtzugänglichen Bereiche erfolgt beim erfindungsgemäßen Verfahren durch Bestrahlung mit UV-Licht. Als Bestrahlungsquellen können dabei prinzipiell alle üblichen UV-Quellen eingesetzt werden, wie Xenon-, Wolfram-, Quecksilber- und Metallhalogenidstrahler sowie UV-Laser verschiedenster Art, beispielsweise Excimer- und Nd/YAG-Laser. Die UV-Emission der Strahler kann hierbei kontinuierlich oder gepulst erfolgen.

Die thermische Härtung in den lichtabgeschatteten Bereichen kann gleichzeitig mit der UV-Bestrahlung, unmittelbar daran anschließend oder erst später in einem separaten thermischen Prozeß erfolgen. Dies geschieht, wie bereits ausgeführt, bei Temperaturen von 80 bis 200°C, vorzugsweise bei 80 bis 150°C. Die zur thermischen Härtung erforderliche Wärme kann durch Infrarotstrahler, Infrarotlaser oder erwärmte Umluft zugeführt werden. Es ist aber auch möglich, den von einem UV-Strahler ausgesandten IR-Strahlungsanteil, wie dies beispielsweise bei Quecksilber- und Xenonstrahlern der Fall ist, auszunutzen oder die von einer heißen Strahlerwandung konvektiv übertragene Wärme. Ferner ist es möglich, die erforderliche Wärme mittels Wärmeleitung über das Substrat oder durch die Bauteile zuzuführen.

Anhand von Ausführungsbeispielen soll die Erfindung noch näher erläutert werden.

Beispiele 1 bis 7

In den Beispielen 1 bis 7 sind Epoxidharzmischungen aufgeführt, die sich für eine Applikation mittels des Dispenserverfahrens eignen. Die in den Beispielen 2, 3, 6 und 7 aufgeführten Mischungen enthalten Ruß und sind deshalb in

tieferen Schichten einer UV-Härtung nicht zugänglich, im Gegensatz zu den Mischungen nach den Beispielen 1, 4 und 5, die keinen Ruß enthalten.

Die Zusammensetzung der verwendeten Mischungen kann Tabelle 1 entnommen werden. Die einzelnen Bestandteile sind dabei in Massenteilen angegeben; die Arylsulfoniumhexafluoroantimonate liegen als Lösung in Propylencarbonat vor (Handelsprodukt). Die Mischungen werden 0,5 h bei Raumtemperatur unter vermindertem Druck (< 10 mbar) und unter Ausschluß von UV-Licht homogenisiert.

Tabelle 1

| Zusammensetzung der Mischungen nach den Beispielen 1 bis 7 | | | | | | | |
|---|---|---|---|---|---|---|---|
| Beispiel Vergleichsbeispiel (*) | 1 (*) | 2 (*) | 3 | 4 | 5 (*) | 6 (*) | 7 |
| Kresolnovolakepoxid | 33,3 | 33,3 | 33,3 | 33,3 | 33,3 | 33,3 | 33,3 |
| Cycloaliphatisches Diepoxid | 33,3 | 33,3 | 33,3 | 33,3 | 33,3 | 33,3 | 33,3 |
| Cycloaliphatisches Monoepoxid | 33,3 | 33,3 | 33,3 | 33,3 | 33,3 | 33,3 | 33,3 |
| Lösung von Arylsulfoniumhexafluoroantimonaten (33 %ig) | 0,5 | 0,5 | 0,5 | 0,5 | 0,5 | 0,5 | 0,5 |
| Benzylthiolaniumhexafluoroantimonat | 0 | 0 | 0,7 | 0,7 | 0 | 0 | 0,7 |
| Ruß | 0 | 0,1 | 0,1 | 0 | 0 | 0,1 | 0,1 |
| Quarzgutmehl (silanisiert) | 0 | 0 | 0 | 0 | 233 | 233 | 233 |

Die Mischungen werden jeweils in Teflonformen mit zylindrischen Vertiefungen von 25 mm Durchmesser eingefüllt und durch UV-Bestrahlung mit einer Quecksilbermitteldrucklampe gehärtet (ca. 100 $mW/cm^2$). Anschließend erfolgt eine thermische Härtung bei 150°C innerhalb von 10 min.

Die im Sinne der Erfindung relevanten Ergebnisse sind in Tabelle 2 zusammengefaßt.

Tabelle 2

| Eingeschaften der Mischungen nach den Beispielen 1 bis 7 | | | | | | | |
|---|---|---|---|---|---|---|---|
| Beispiel Vergleichsbeispiel (*) | 1 (*) | 2 (*) | 3 | 4 | 5 (*) | 6 (*) | 7 |
| UV-Bestrahlungszeit (min) | 3 | 5 | 5 | 3 | 3 | 5 | 5 |
| Härtbare Schichtdicke durch reine UV-Bestrahlung (mm) | > 2 | 0,5 | 0,5 | > 2 | > 2 | 0,7 | 0,7 |
| Härtung in tieferen Bereichen bei 150°C nach 10 min | nein | nein | ja | ja | nein | nein | ja |
| Viskositätsvervielfachung in 6 Monaten | < 2 | < 2 | < 2 | < 2 | < 1,2 | < 1,2 | < 1,2 |

Es zeigt sich, daß rußhaltige Mischungen durch reine UV-Bestrahlung nur in dünnen Schichten härtbar sind. Die nach der UV-Härtung noch flüssigen Bereiche in den tieferen Schichten können nur bei Anwesenheit eines Benzylthiolaniumsalzes (Beispiele 3 und 7), entsprechend der Erfindung, thermisch gehärtet werden. Hierbei erreicht der gesamte Formkörper nach einer Härtung von 10 min bei 150°C eine Glastemperatur $T_G$ > 150°C (Maximum des Verlustfaktors in der dynamisch-mechanischen Analyse bei einer Aufheizrate von 3 K/min und einer Frequenz von 1 Hz). Bei Abwesenheit des Benzylthiolaniumsalzes bleiben die tieferen Bereiche flüssig (Beispiele 2 und 6).

Diese Ergebnisse werden mit ungefüllten (Beispiele 1 bis 4) und auch mit quarzgutmehlhaltigen Mischungen (Beispiele 5 bis 7) erhalten. Die geforderte Lagerstabilität wird durch alle Mischungen erreicht. Mit den Mischungen der Beispiele 5 bis 7 können ungehäuste, gebondete IC's auf Leiterplatten und Hybridschaltungen lokal, beispielsweise mit dispenserapplizierten Tropfen, abgedeckt werden. Speziell für Hybridschaltungen, bei denen ein aktiver Laserabgleich durchgeführt wird, ist ein Rußzusatz erforderlich (Beispiele 2, 3, 6 und 7), d.h. eine vollständige Aushärtung ist somit nur bei Anwendung der erfindungsgemäßen Maßnahmen möglich.

Beispiele 8 bis 11

In den Beispielen 8 bis 11 sind Epoxidharzmischungen aufgeführt, die sich für eine Tauchapplikation eignen. Die Zusammensetzung der verwendeten Mischungen kann Tabelle 3 entnommen werden. Die einzelnen Bestandteile sind dabei in Massenteilen angegeben; die Arylsulfoniumhexafluoroantimonate liegen als Lösung in Propylencarbonat vor

(Handelsprodukt). Die Mischungen werden 0,5 h bei Raumtemperatur unter vermindertem Druck (< 10 mbar) und unter Ausschluß von UV-Licht homogenisiert.

Tabelle 3

| Zusammensetzung der Mischungen nach den Beispielen 8 bis 11 | | | | |
|---|---|---|---|---|
| Beispiel Vergleichsbeispiel (*) | 8 | 9 | 10 (*) | 11 (*) |
| Cycloaliphatisches Diepoxid | 62,5 | 50 | 50 | 50 |
| Triglycerid von epoxidiertem Sojabohnenöl | 25,0 | 20 | 20 | 20 |
| Cycloaliphatischer Alkohol | 12,5 | 10 | 10 | 10 |
| Polypropylenglykolmonomethacrylat | 0 | 20 | 20 | 20 |
| Lösung von Arylsulfoniumhexafluoroantimonaten (33 %ig) | 1 | 1 | 1 | 0 |
| Benzylthiolaniumhexafluoroantimonat | 0,5 | 0,5 | 0 | 0,5 |

In Tabelle 4 sind die im Zusammenhang mit der Erfindung wesentlichen Eigenschaften der Mischungen 9 bis 11 zusammengefaßt. Bei der Mischung nach Beispiel 8 beträgt die Zeit bis zur Verdopplung der Ausgangsviskosität 2 Monate.

Tabelle 4

| Eigenschaften der Mischungen nach den Beispielen 9 bis 11 | | | |
|---|---|---|---|
| Beispiel Vergleichsbeispiel (*) | 9 | 10 (*) | 11 (*) |
| Gelierzeit bei 130°C | 75 s | > 2 h | 70 s |
| Gelierzeit bei UV-Bestrahlung | 30 s | 30 s | > 30 min |
| Viskositätsvervielfachung in 6 Monaten | < 2 | < 2 | < 2 |

Tabelle 4 ist zu entnehmen, daß für eine Härtung durch UV-Bestrahlung und durch Wärmezufuhr das Vorhandensein beider Initiatoren erforderlich ist. Beispiel 9 zeigt im Vergleich zu Beispiel 11, daß das Arylsulfoniumhexafluoroantimonat die Gelierzeit bei Wärmezufuhr (130°C) nicht wesentlich beeinflußt. Den Beispielen 9 und 10 ist andererseits zu entnehmen, daß das Benzylthiolaniumhexafluoroantimonat die Gelierzeit bei UV-Bestrahlung nicht beeinflußt (Schichtdicke: 0,5 mm; Metallhalogenidstrahler; UVA-Leistungsdichte: 25 $mW/cm^2$). Die geforderte Lagerstabilität der Mischungen ist auch bei gleichzeitigem Vorhandensein beider Initiatoren gewährleistet (Beispiel 9). Beispiel 9 zeigt - im Vergleich zu Beispiel 8 - ferner, daß durch den Zusatz von Methacrylat die Lagerstabilität von 2 Monaten auf über 6 Monate erhöht wird.

Mit der Mischung 9 können Leiterplattenflachbaugruppen lackiert werden. Hierzu werden die Flachbaugruppen in das niederviskose Harz langsam ein- und ausgetaucht. Nach einer kurzen Abtropfzeit erfolgt die Härtung des Lackes an den lichtzugänglichen Stellen durch UV-Bestrahlung und in den lichtabgeschatteten Bereichen thermisch bei 125°C.

**Patentansprüche**

**1.** Verfahren zur Beschichtung oder Verklebung von elektronischen Bauelementen und Baugruppen mit lagerstabilen Reaktionsharzmischungen,
wobei Reaktionsharzmischungen verwendet werden, die

- ein kationisch härtbares, lösungsmittelfreies Epoxidharz,
- ein Triarylsulfoniumsalz mit Hexafluorophosphat, Hexafluoroarsenat oder Hexafluoroantimonat als Anion, mit einem Massengehalt von 0,01 bis 5 % (bezogen auf Epoxidharz), und
- ein Benzylthiolaniumsalz mit Hexafluorophosphat, Hexafluoroarsenat oder Hexafluoroantimonat als Anion, mit einem Massengehalt von 0,01 bis 5 % (bezogen auf Epoxidharz), sowie
- gegebenenfalls übliche Zusatzstoffe enthalten,

und wobei die Reaktionsharzmischungen durch UV-Bestrahlung und thermisch gehärtet werden.

2. Verfahren nach Anspruch 1, **dadurch gekennzeichnet**, daß die thermische Härtung bei Temperaturen von 80 bis 200°C durchgeführt wird.

3. Verfahren nach Anspruch 1 oder 2, **dadurch gekennzeichnet**, daß als kationisch härtbares Epoxidharz Glycidylether auf der Basis von Bisphenol A, Bisphenol F oder Novolaken, lineare aliphatische Epoxidharze und cycloaliphatische Epoxidharze eingesetzt werden.

4. Verfahren nach einem der Ansprüche 1 bis 3, **dadurch gekennzeichnet**, daß dem Epoxidharz eine hydroxylgruppenhaltige organische Verbindung, insbesondere ein Polyoxyalkylenpolyol, ein Polyalkylenpolyol oder eine cycloaliphatische Hydroxylverbindung, oder deren Vinylether, zugegeben wird.

5. Verfahren nach einem oder mehreren der Ansprüche 1 bis 4, **dadurch gekennzeichnet**, daß als Triarylsulfoniumsalz Verbindungen folgender Struktur eingesetzt werden:

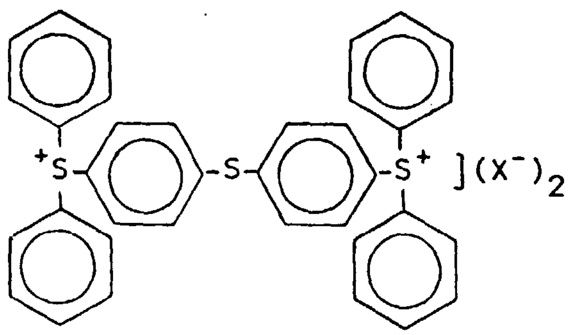

oder

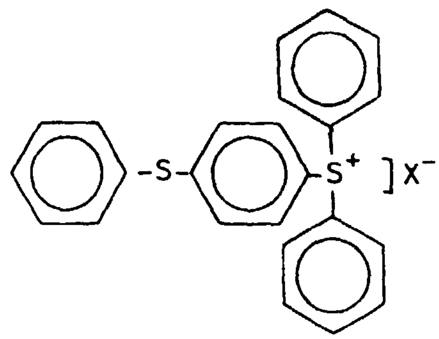

mit $X^- = PF_6^-$, $AsF_6^-$ oder $SbF_6^-$.

6. Verfahren nach einem oder mehreren der Ansprüche 1 bis 5, **dadurch gekennzeichnet**, daß als Benzylthiolaniumsalz Verbindungen folgender Struktur eingesetzt werden:

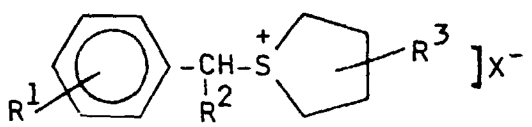

,

wobei folgendes gilt:

$R^1$ = Wasserstoff, Alkyl, Aryl, Alkoxy, Thioether, Halogen, CN oder $NO_2$;
$R^2$ = Wasserstoff, Alkyl oder Aryl;
$R^3$ = Wasserstoff, Alkyl oder Aryl oder der Thiolanring ist Bestandteil eines aromatischen Systems;
$X^-$ = $PF_6^-$, $AsF_6^-$ oder $SbF_6^-$.

7. Verfahren nach einem oder mehreren der Ansprüche 1 bis 6, **dadurch gekennzeichnet**, daß den Reaktionsharzmischungen tertiäre Amine, mit einem Massengehalt von 0,001 bis 1 % (bezogen auf Epoxidharz), zugesetzt werden.

8. Verfahren nach einem oder mehreren der Ansprüche 1 bis 6, **dadurch gekennzeichnet**, daß den Reaktionsharzmischungen (Meth)acrylate, mit einem Massengehalt von 1 bis 30 % (bezogen auf Epoxidharz), zugesetzt werden.

9. Anwendung des Verfahrens nach einem oder mehreren der Ansprüche 1 bis 8 zur flächigen Beschichtung von Baugruppen der Elektronik, insbesondere zur Lackierung von Leiterplattenflachbaugruppen.

10. Anwendung des Verfahrens nach einem oder mehreren der Ansprüche 1 bis 8 zur lokalen Abdeckung von mikroelektronischen Bauelementen, wobei Farbstoff oder Pigment enthaltende Reaktionsharzmischungen mit einem hohen Anteil an mineralischen Füllstoffen zum Einsatz gelangen.

## Claims

1. Method for coating or bonding electronic components and modules with storage-stable reaction resin mixtures, with reaction resin mixtures being used which include

    - a cationically hardenable, solvent-free epoxy resin,
    - a triarylsulphonium salt with hexafluorophosphate, hexafluoroarsenate or hexafluoroantimonate as anion, having a mass content of 0.01 to 5% (in relation to epoxy resin), and
    - a benzylthiolanium salt with hexafluorophosphate, hexafluoroarsenate or hexafluoroantimonate as anion, having a mass content of 0.01 to 5% (in relation to epoxy resin), and
    - perhaps usual added substances,

    and with the reaction resin mixtures being hardened by way of UV irradiation and heat.

2. Method according to claim 1, characterized in that the thermal hardening is carried out at temperatures of 80 to 200°C.

3. Method according to claim 1 or 2, characterized in that as cationically hardenable epoxy resin glycidylethers based on bisphenol A, bisphenol F or novolaks, linear aliphatic epoxy resins and cycloaliphatic epoxy resins are used.

4. Method according to one of claims 1 to 3, characterized in that there is added to the epoxy resin an organic compound containing hydroxyl groups, in particular a polyoxyalkylenepolyol, a polyalkylenepolyol or a cycloaliphatic hydroxyl compound, or vinyl ethers thereof.

5. Method according to one or more of claims 1 to 4, characterized in that compounds of the following structure are used as triarylsulphonium salt:

    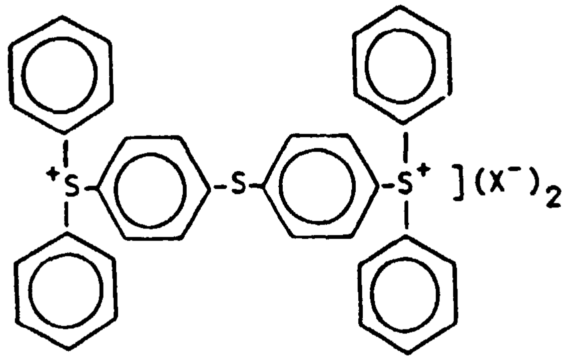

    or

    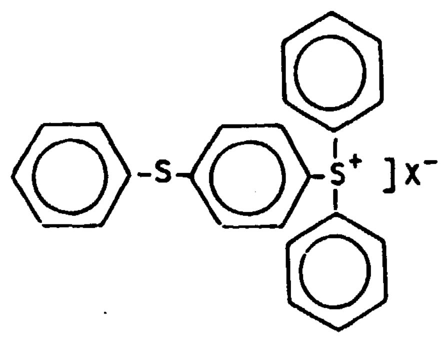

    where $X^- = PF_6^-$, $AsF_6^-$ or $SbF_6^-$.

6. Method according to one or more of claims 1 to 5, characterized in that compounds of the following structure are used as benzylthiolanium salt:

    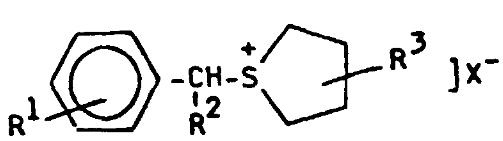

    whereby the following applies:

    $R^1$ = hydrogen, alkyl, aryl, alkoxy, thioether, halogen, CN or $NO_2$;
    $R^2$ = hydrogen, alkyl or aryl;
    $R^3$ = hydrogen, alkyl or aryl or the thiolane ring is a constituent of an aromatic system;

$X^- =$ $PF_6^-$, $AsF_6^-$ or $SbF_6^-$.

**7.** Method according to one or more of claims 1 to 6, characterized in that there are added to the reaction resin mixtures tertiary amines with a mass content of 0.001 to 1% (in relation to epoxy resin).

**8.** Method according to one or more of claims 1 to 6, characterized in that there are added to the reaction resin mixtures (meth)acrylates, having a mass content of 1 to 30% (in relation to epoxy resin).

**9.** Use of the method according to one or more of claims 1 to 8 for the laminar coating of electronics modules, in particular to lacquer-coat flat printed circuit board modules.

**10.** Use of the method according to one or more of claims 1 to 8 for the local covering of microelectronic components, whereby reaction resin mixtures containing colorant or pigment with a high portion of mineral fillers are used.

**Revendications**

**1.** Procédé pour le revêtement ou le collage de constituants électroniques et d'ensembles électroniques en pièces détachées avec des mélanges réactionnels sous forme de résines stables à l'entreposage, dans lequel on utilise des mélanges réactionnels sous forme de résines qui contiennent

- une résine époxy exempte de solvant durcissable par voie cationique,
- un sel de triarylsulfonium avec de l'hexafluorophosphate, de l'hexafluoroarséniate ou de l'hexafluoroantimoniate à titre d'anion, possédant une teneur massique de 0,01 à 5% (rapportés à la résine époxy), et
- un sel de benzylthiolanium avec de l'hexafluorophosphate, de l'hexafluoroarséniate ou de l'hexafluoroantimoniate à titre d'anion, possédant une teneur massique de 0,01 à 5% (rapportés à la résine époxy), ainsi que
- le cas échéant, des additifs habituels,

et dans lequel on durcit les mélanges réactionnels sous forme de résines par rayonnement UV et par voie thermique.

**2.** Procédé selon la revendication 1, caractérisé en ce qu'on effectue le durcissement thermique à des températures de 80 à 200°C.

**3.** Procédé selon la revendication 1 ou 2, caractérisé en ce qu'on met en oeuvre, à titre de résine époxy durcissable par voie cationique, de l'éther glycidylique à base de Bisphénol A, de Bisphénol F ou de novolaques, des résines époxy aliphatiques linéaires et des résines époxy cycloaliphatiques.

**4.** Procédé selon l'une quelconque des revendications 1 à 3, caractérisé en ce qu'on ajoute à la résine époxy un composé organique contenant des groupes hydroxyle, en particulier un polyoxyalkylènepolyol, un polyalkylènepolyol ou un composé hydroxylé cycloaliphatique ou encore ses éthers vinyliques.

**5.** Procédé selon une ou plusieurs des revendications 1 à 4, caractérisé en ce qu'on met en oeuvre, à titre de sel de triarylsulfonium, des composés répondant aux formules ci-après:

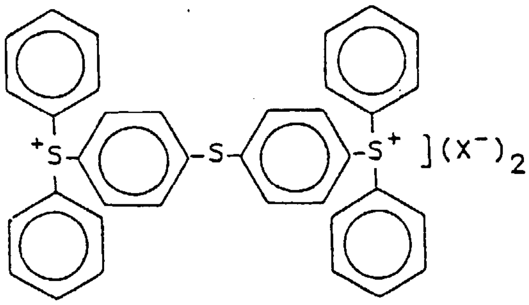

ou

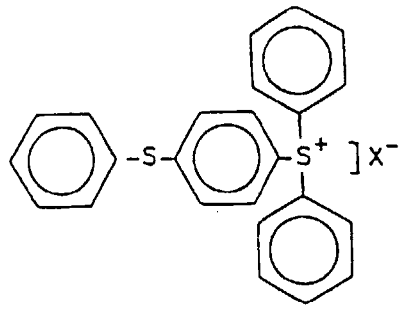

dans lesquelles $X^-$ représente $PF_6^-$, $AsF_6^-$ ou $SbF_6^-$.

**6.** Procédé selon une ou plusieurs des revendications 1 à 5, caractérisé en ce qu'on met en oeuvre, à titre de sel de benzylthiolanium, des composés répondant à la formule ci-après:

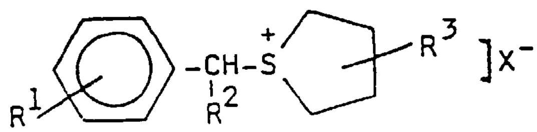

,

dans laquelle:

$R^1$ représente un atome d'hydrogène, un groupe alkyle, un groupe aryle, un groupe alcoxy, un groupe thioéther, un atome d'halogène, CN ou $NO_2$,
$R^2$ représente un atome d'hydrogène, un groupe alkyle ou un groupe aryle,
$R^3$ représente un atome d'hydrogène, un groupe alkyle ou un groupe aryle ou encore le noyau thiolane fait partie d'un système aromatique;
$X^-$ représente $PF_6^-$, $AsF_6^-$ ou $SbF_6^-$.

**7.** Procédé selon une ou plusieurs des revendications 1 à 6, caractérisé en ce qu'on ajoute aux mélanges réactionnels sous forme de résines des amines tertiaires possédant une teneur massique de 0,001 à 1% (rapporté à la résine époxy).

**8.** Procédé selon une ou plusieurs des revendications 1 à 6, caractérisé en ce qu'on ajoute aux mélanges réactionnels sous forme de résines des (méth)acrylates possédant une teneur massique de 1 à 30% (rapportés à la résine époxy).

**9.** Application du procédé selon une ou plusieurs des revendications 1 à 8, pour le revêtement superficiel d'ensembles électroniques en pièces détachées, en particulier pour le laquage de plaques à circuits imprimés.

**10.** Application du procédé selon une ou plusieurs des revendications 1 à 8, pour le recouvrement local de composants micro-électroniques, dans laquelle on met en oeuvre des mélanges réactionnels sous forme de résines contenant un colorant ou un pigment, possédant une fraction élevée en substances de remplissage minérales.